# EUROPÄISCHE PATENTANMELDUNG

(11) **EP 1 229 592 A2**
(43) Veröffentlichungstag der Anmeldung: **07.08.2002**
(21) Anmeldenummer: 01126169.0
(22) Anmeldetag: 03.11.2001
(51) Int. Cl.: H01L 31/0352, H01L 31/02, H01L 31/18

(54) **Optischer Detektor und Verfahren zum Herstellen einer Anordnung mehrerer Halbleiterschichten**

(30) Priorität: 31.01.2001 DE 10104015
(71) Anmelder: ROBERT BOSCH GMBH, 70442 Stuttgart (DE)
(72) Erfinder: Muehlnickel, Gerd, 71522 Backnang (DE); Hirche, Klaus, 71332 Waiblingen (DE); Warth, Martin, 71409 Schwaikheim (DE)

(57) **Zusammenfassung**

Die Erfindung betrifft einen optischen Detektor mit einer Anordnung mehrerer Halbleiterschichten (10, 12, 14) mit mindestens einer in einem bestimmten Wellenlängenbereich absorbierenden Zone (20) und mindestens einer in dem bestimmten Wellenlängenbereich zumindest teilweise lichtdurchlässigen Zone (22), wobei eine Halbleiterschicht (14) in dem bestimmten Wellenlängenbereich absorbierend ist und eine darunter liegende Halbleiterschicht (10, 12) in dem bestimmten Wellenlängenbereich zumindest teilweise lichtdurchlässig ist, wobei die mindestens eine lichtdurchlässige Zone (22) durch eine Unterbrechung (24) der absorbierenden Halbleiterschicht (14) realisiert ist und wobei eine die Unterbrechung (24) umgebende Oberfläche der absorbierenden Halbleiterschicht (14) und zumindest ein Teil der Oberfläche der zumindest teilweise lichtdurchlässigen Halbleiterschicht (10, 12) eine durchgängige Dotierung (26) aufweist. Die Erfindung betrifft ferner ein Verfahren zum Herstellen einer Anordnung mehrerer Halbleiterschichten und eine Verwendung eines optischen Detektors.

## Beschreibung

Die Erfindung betrifft einen optischen Detektor mit einer Anordnung mehrerer Halbleiterschichten mit mindestens einer in einem bestimmten Wellenlängenbereich absorbierenden Zone und mindestens einer in dem bestimmten Wellenlängenbereich zumindest teilweise lichtdurchlässigen Zone, wobei eine Halbleiterschicht in dem bestimmten Wellenlängenbereich absorbierend ist und eine darunter liegende Halbleiterschicht in dem bestimmten Wellenlängenbereich zumindest teilweise lichtdurchlässig ist und wobei die mindestens eine lichtdurchlässige Zone durch eine Unterbrechung der absorbierenden Halbleiterschicht realisiert ist. Die Erfindung betrifft ferner ein Verfahren zum Herstellen einer Anordnung mehrerer Halbleiterschichten mit mindestens einer in einem bestimmten Wellenlängenbereich absorbierenden Zone und mindestens einer in dem bestimmten Wellenlängenbereich zumindest teilweise lichtdurchlässigen Zone, wobei eine Halbleiterschicht in dem bestimmten Wellenlängenbereich absorbierend ist und eine darunter liegende Halbleiterschicht in dem bestimmten Wellenlängenbereich zumindest teilweise lichtdurchlässig ist und wobei die mindestens eine lichtdurchlässige Zone durch eine Unterbrechung der absorbierenden Halbleiterschicht realisiert ist.

### Stand der Technik

Gattungsgemäße optische Detektoren und gattungsgemäße Verfahren sind bekannt. Sie kommen beispielsweise bei optischen positionsabhängigen Detektoren zum Einsatz, welche eine integrierte Photodiodenanordnung aufweisen. Derartige optischen Detektoren haben eine oder mehrere aktive Zonen, und sie haben Bereiche, in denen sie zumindest in einem bestimmten optischen Wellenlängenbereich transparent oder nahezu transparent sind. Mit dem Begriff "aktive Zone" wird vorliegend ein Bereich bezeichnet, in dem einfallendes Licht absorbiert und in einen Photostrom umgesetzt wird.

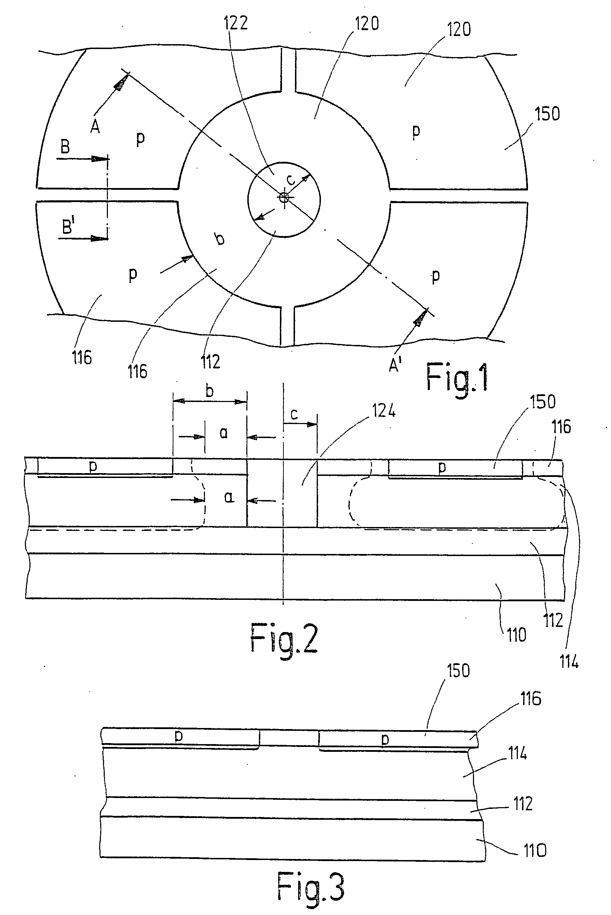

Die Figuren 1 bis 5 zeigen Beispiele von Halbleiterschichtanordnungen des Standes der Technik in verschiedenen Ansichten.

In Figur 1 ist eine Draufsicht auf einen Teil eines Vier-Quadranten-Detektors gezeigt. Dieser Vier-Quadranten-Detektor hat in seinem Zentrum eine transparente Zone 122. Der in das Zentrum des Detektors fallende Strahl oder ein bestimmter Anteil der optischen Leistung des Strahls passiert den Detektor ungedämpft beziehungsweise nahezu ungedämpft. Weicht die Strahlposition von der Mitte des Detektors ab, so wird das einfallende Licht in einem der äußeren Sektoren des Vier-Quadranten-Detektors detektiert. Die Detektion des auf die äußeren Sektoren einfallenden Lichtes erfolgt durch die Erzeugung eines Photostroms. Zu diesem Zwecke sind die Bereiche 150 der absorbierenden Schicht 120 p-dotiert.

Figur 2 zeigt einen Schnitt durch die Anordnung gemäß Figur 1 entlang der in Figur 1 mit A-A' gekennzeichneten Linie. In Figur 2 sind die Anordnung der verschiedenen Schichten und die p-dotierten Bereiche 150 zu erkennen.

Auf einer n⁺-dotierten Substratschicht 110 aus InP ist eine n-dotierte InP-Schicht 112 angeordnet. Dieser Schicht 112 folgt eine i-InGaAs-Schicht 114. Oberhalb der Schicht 114 ist eine InP-Schicht angeordnet, welche p-dotierte Bereiche 150 hat. Die p-dotierten Bereiche 150 dringen ebenfalls noch in die i-InGaAs-Schicht 114 ein. Für eine Wellenlänge von 1064 nm zeigt Figur 2 eine gattungsgemäße Anordnung. Für Licht dieser Wellenlänge sind nämlich die Schichten aus InP 110, 112 und 116 transparent. Die InGaAs-Schicht 114 ist hingegen eine absorbierende Schicht. Damit der Schichtaufbau insgesamt einen zentralen lichtdurchlässigen Bereich aufweist, ist in die absorbierende Schicht 114 und die darüber liegende InP-Schicht 116 eine Unterbrechung 124 eingebracht. Diese Unterbrechung 124 mit dem Radius c definiert die lichtdurchlässige Zone 122 des dargestellten optischen Detektors.

Aufgrund der Dotierungen der unterschiedlichen Schichten hat die Anordnung die Eigenschaft einer pin-Diode mit einer intrinsischen Schicht 114. In der in der intrinsischen Schicht 114 ausgebildeten Raumladungszone, welche durch eine unterbrochene Linie angedeutet ist, findet eine besonders effektive Umsetzung des absorbierten Lichts in einen Photostrom statt. Daher ist man bestrebt, den Abstand a zwischen der Raumladungszone und der lichtdurchlässigen Zone 122 besonders klein zu gestalten. Mit anderen Worten: man ist bestrebt, eine "Totzone" zu verringern. Der minimal erzielbare Abstand a beziehungsweise, damit im Zusammenhang stehend, der minimal erzielbare Abstand b hängt von mehreren Faktoren ab.
1. Herstellungsbedingte Sicherheitsabstände in Verbindung mit einer Maskentechnik beziehungsweise einer Strukturierung spielen eine Rolle. Die Summe aus der Variation von Unterdiffusion und Unterätzung und des maximalen Justierfehlers der Masken werden bei typischen Schichtdicken im InP/InGaAs-Materialsystem auf zirka 5 µm geschätzt. Die Mittelwerte von Unterdiffusion und Unterätzung können zwar durch entsprechenden Vorhalt beim Maskenlayout ausgeglichen werden. Als zusätzlich erforderlicher Sicherheitsabstand treten aber die zu erwartenden Varianzen auf. Da der aktive, das heißt der absorbierende, und der transparente Bereich mit zwei verschiedenen Maskenschritten erzeugt werden, kann zusätzlich ein Justierfehler auftreten.
2. Ferner gibt es einen Einfluss von Oberflächenzuständen. Oberflächenzustände an den Flanken des absorbierenden Bereichs 114, 120 führen zu einer Bandverbiegung im Inneren des Halbleiters, das heißt gemäß Figur 1 in der InGaAs-Schicht 114. Die Grenze der mit einer unterbrochenen Linie gekennzeichneten Raumladungszone sollte außerhalb dieses Bereichs liegen. Die Breite dieser Zone kann in InGaAs bei einer Hintergrunddotierung von 10¹⁴ cm⁻³ bei zirka 3,4 µm liegen. Bei einer Hintergrunddotierung von 10¹³ cm⁻³ kann die Breite dieser Zone bei zirka 10,6 µm liegen, wobei diese Werte abhängig von der Natur der Oberflächenzustände sind.
3. Weiterhin kann eine Variation der seitlichen Ausdehnung der Raumladungszone auftreten. Diese hängt wiederum von der Variation der Hintergrunddotierung und der Vorspannung ab. Kritische Größe ist auch hier wieder die zu erwartende Schwankungsbreite. Der Erwartungswert (Mittelwert) allein könnte durch einen entsprechenden Vorhalt im Maskenlayout ausgeglichen werden. Bei Werten für die Hintergrunddotierung im Bereich von 10¹³ cm⁻³ bis 10¹⁵ cm⁻³ ist von einer Variation größer 5 µm auszugehen.

Im Allgemeinen geht man davon aus, dass die genannten Effekte 2 (Einfluss von Oberflächenzuständen) und 3 (Variation der seitlichen Ausdehnung der Raumladungszone) den Effekt 1 (herstellungsbedingte Sicherheitsabstände) überwiegen. Insgesamt ist von einer minimalen effektiven Breite a von 10 µm bis 20 µm bei einer Realisierung im InP/InGaAs/InGaAsP-Materialsystem nach Figur 1 oder Figur 2 auszugehen. Die sich effektiv ergebende Breite der Totzone a wird in der Realisierung aus den genannten Gründen starken Schwankungen unterworfen sein.

Zu weiteren Erläuterungen des in den Figuren 1 und 2 dargestellten Schichtaufbaus ist in Figur 3 ein Schnitt entlang der in Figur 1 mit B-B' gekennzeichneten Linie dargestellt. Man erkennt die drei Schichten n⁺-InP 110, n-InP 112, i-InGaAs 114 und InP 116 mit den p-dotierten Bereichen 150. Im Bereich dieses Schnittes ist die Schichtanordnung durchgängig absorbierend.

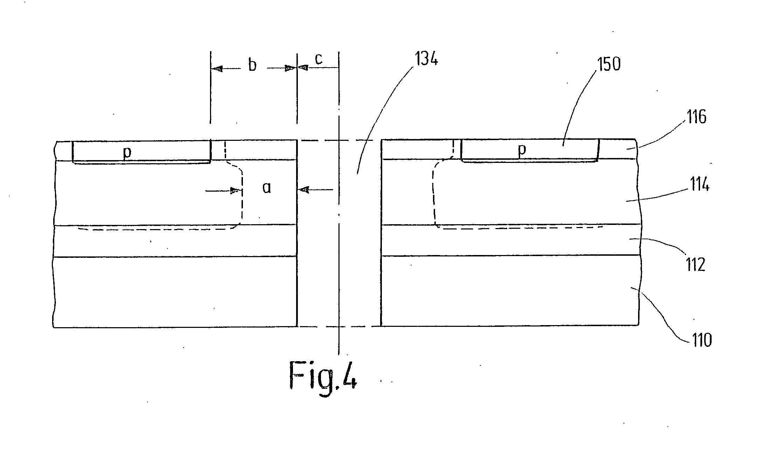

In Figur 4 ist eine weitere Halbleiteranordnung dargestellt, welche bis auf die Gestaltung des lichtdurchlässigen Bereiches der Anordnung gemäß Figur 2 entspricht. In der Darstellung gemäß Figur 4 ist der lichtdurchlässige Bereich als Durchgangsloch 134 realisiert. Auch bei einer derartigen Anordnung ist die Totzone größer als erwünscht.

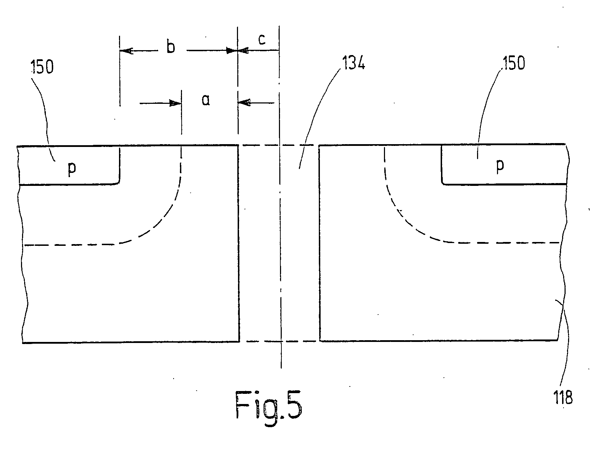

Figur 5 zeigt eine weitere Ausführungsform eines optischen Detektors, wobei hier allerdings Silizium als Halbleitermaterial verwendet wird. Die Darstellung ist wiederum ein Schnitt entlang der Linie A-A' gemäß Figur 1. Insofern ist die Darstellung in Figur 1 nicht auf die in Figur 2 gezeigte Schichtanordnung und die in der zugehörigen Beschreibung genannten Materialien beschränkt. In Figur 5 ist eine Siliziumschicht 118 mit p-dotierten Zonen 150 versehen. Der transparente Bereich mit dem Radius c ist in der Anordnung gemäß Figur 5 durch ein Durchgangsloch 134 realisiert. Der Abstand b zwischen dem p-dotierten Bereich 150 und dem als Durchgangsloch 134 realisierten lichtdurchlässigen Bereich ist wiederum mit b gekennzeichnet. Der Bereich mit der Abmessung a kennzeichnet wiederum die Totzone des Detektors.

Ein bekannter Vorteil des Materialsystems InP/InGaAsP/InGaAs gemäß Figur 2 gegenüber Silizium gemäß Figur 5 besteht darin, dass die Weite der erforderlichen Raumladungszone und damit die Schichtdicke im InGaAs gegenüber Silizium um Größenordnungen geringer ist.

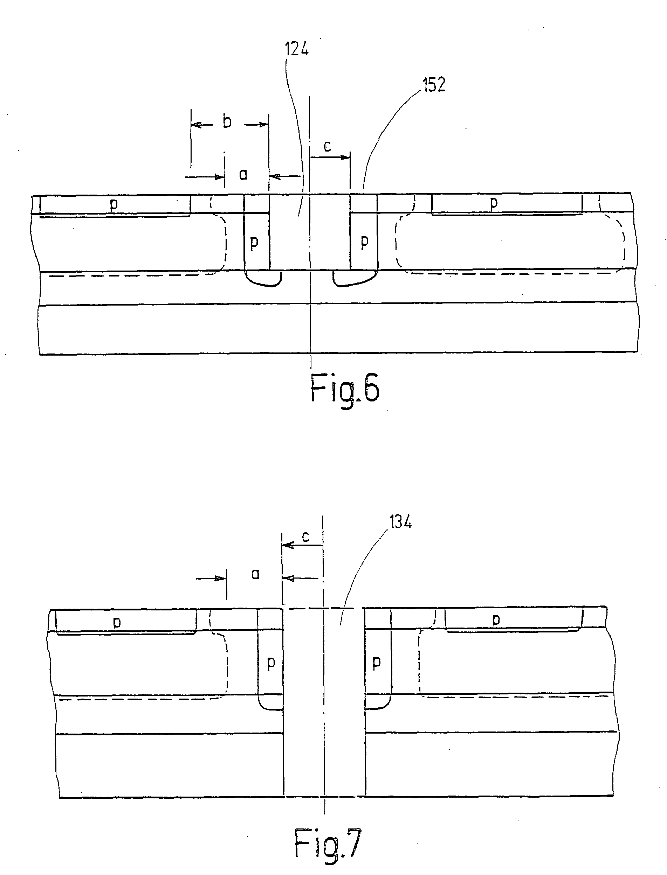

Zur Verringerung von Oberflächenleckströmen ist es ebenfalls möglich, Anordnungen zu verwenden, welche beispielhaft in den Figuren 6 und 7 dargestellt sind. Die in Figur 6 dargestellt Anordnung entspricht weitgehend der in Figur 2 dargestellten Anordnung. Zusätzlich ist eine sogenannte "Guard"-Ringstruktur um die Unterbrechung 124 angeordnet, das heißt eine zusätzliche, von der aktiven Zone elektrisch getrennte Diffusionszone. Der Guardring 152 ist durch eine p-Dotierung um die Unterbrechung 124 realisiert. Der Platzbedarf für die resultierende Totzone a für eine derartige Struktur liegt aber ebenfalls in der Größenordnung 10 µm bis 20 µm.

In Figur 7 ist eine ähnliche Anordnung wie in Figur 6 gezeigt. Hier wird der transparente Bereich durch ein Durchgangsloch 134 realisiert.

Es ist ebenfalls möglich, Guard-Ringstrukturen bei Silizium zu verwenden. Hier ist im Hinblick auf die Minimierung der Totzone jedoch wiederum als erschwerend zu verzeichnen, dass die Weite der Raumladungszone sehr groß ist (beispielsweise größer als 100 µm). Die Guard-Ringstruktur kann eine Breite im Bereich von größer 50 µm besitzen.

### Vorteile der Erfindung

Die Erfindung baut auf dem gattungsgemäßen Detektor dadurch auf, dass eine die Unterbrechung umgebende Oberfläche der absorbierenden Halbleiterschicht und zumindest ein Teil der Oberfläche der zumindest teilweise lichtdurchlässigen Halbleiterschicht eine durchgängige Dotierung aufweist. Auf diese Weise ist es möglich, den Übergangsbereich zwischen absorbierenden und transparenten Zonen sehr klein zu halten. Eine Generation von Ladungsträgern durch Absorption von Licht kann bei der erfindungsgemäßen Anordnung auch im Flankenbereich der Unterbrechung stattfinden. Die zumindest teilweise lichtdurchlässigen Zonen schließen direkt an den Flankenbereich an. Der effektive Übergangsbereich kann somit im Wesentlichen auf die Eindringtiefe des dotierten Bereiches beschränkt werden und damit wesentlich kleiner als 10 µm sein. Typische Werte liegen bei 0,5 µm bis 1 µm. Als weiterer Vorteil ist zu nennen, dass im Vergleich zum Stand der Technik die zu erwartende Breite des Übergangsbereiches wesentlich reproduzierbarer ist und im Rahmen der Varianz der Eindringtiefe der Diffusion liegt. Es ist möglich, die absorbierende Zone und die zumindest teilweise lichtdurchlässige Zone in einem einzigen Maskenschritt zu definieren, bei welchem die absorbierende Schicht in dem Bereich entfernt wird, in welchem die lichtdurchlässige Zone entstehen soll. Somit weist der zumindest teilweise lichtdurchlässige Bereich zum Beispiel bei kreisförmigen Strukturen keine Exzentrizität bezüglich der inneren Begrenzung des absorbierenden Bereiches auf.

Vorzugsweise ist die absorbierende Halbleiterschicht InGaAs, und die zumindest teilweise lichtdurchlässige Halbleiterschicht ist InP. Damit ist der Detektor vorzugsweise bei einer optischen Wellenlänge zwischen 900 nm und 1200 nm einsetzbar. In diesem Wellenlängenbereich kann die Dicke der Absorptionsschicht gering gehalten werden, beispielsweise kleiner als 5 µm, und es ist kein durchgehendes Loch erforderlich. Vielmehr muss lediglich die Absorptionsschicht lokal entfernt werden. Das Trägersubstrat aus InP ist für optische Wellenlängen oberhalb von 900 nm transparent.

Vorzugsweise ist die durchgängige Dotierung eine p-Dotierung, und die zumindest teilweise lichtdurchlässige Halbleiterschicht ist n-dotiert. Somit arbeitet die Anordnung nach dem Prinzip einer pin-Diode, wobei eine schwach dotierte innere Schicht zwischen einer p-Schicht und einer n-Schicht angeordnet ist. Mit einer solchen Struktur wird eine hohe Lichtintensität in dem Bereich zwischen der p- und der n-Schicht absorbiert. Eine pin-Struktur hat den weiteren Vorteil gegenüber einem herkömmlichen pn-Übergang, dass die p- und n-Bereiche einen größeren Abstand zueinander haben. Folglich ist die Kapazität der Diode geringer, was zu einer höheren Ansprechgeschwindigkeit führt.

Bevorzugt sind zwei zumindest teilweise lichtdurchlässige Halbleiterschichten mit unterschiedlichen Dotierungskonzentrationen vorgesehen. Eine stark dotierte Schicht ist als Trägersubstrat vorgesehen, während eine schwächer dotierte Schicht die obere n-dotierte Schicht bildet, in welche teilweise der durchgängige p-dotierte Bereich eindringt.

Ebenfalls kann es nützlich sein, wenn die Oberflächen der Anordnung mehrerer Halbleiterschichten zumindest teilweise mit einer Antireflexionsschicht versehen sind. Derartige Antireflexionsschichten verringern die Verluste durch Reflexion, wobei sie auf der Vorderseite und der Rückseite des optischen Detektors angebracht sein können.

Die Erfindung ist in vorteilhafter Weise dadurch weitergebildet, dass an der durchgängigen p-Dotierung ein p-Kontakt vorgesehen ist und dass an der n-dotierten teilweise lichtdurchlässigen Halbleiterschicht ein n-Kontakt vorgesehen ist. Der Bereich der p-dotierten durchgängigen Schicht kann somit zur Anbringung eines elektrischen Kontaktes dienen, während die Rückseite, das heißt die Substratseite der Halbleiteranordnung zur Anbringung eines n-Kontaktes verwendet wird.

Nach dem Stand der Technik für pin-Dioden kann der n-Kontakt auch auf der Oberseite angebracht werden.

Nützlicherweise ist die zumindest teilweise lichtdurchlässige Halbleiterschicht abgedünnt. Dies kann sinnvoll sein, wenn besondere Anforderungen an die Güte der optischen Transparenz gestellt sind, zum Beispiel die Forderung nach einem geringen optischen Wellenfrontfehler. In diesem Fall kann das Substrat von der Rückseite her bis auf eine geringere Dicke ausgehend von einer Dicke von 350 µm bis 50 µm abgedünnt werden.

Zur Verbesserung der Transparenz kann es ebenfalls nützlich sein, wenn ein Durchgangsloch in der zumindest teilweise lichtdurchlässigen Halbleiterschicht im Bereich der Unterbrechung der ersten absorbierenden Halbleiterschicht vorgesehen ist. Zur Herstellung eines solchen durchgehenden Loches kann eine nass- beziehungsweise trockenätztechnische Strukturierung oder eine Laserschneidtechnik angewendet werden. Die Ätzung kann von der Vorderseite oder von der Rückseite der Halbleiteranordnung erfolgen.

Nützlicherweise sind die zumindest teilweise leitende(n) Zone(n) und die absorbierende(n) Zone(n) zirkularsymmetrisch. Eine derartige Anordnung eignet sich beispielsweise für die Justierung verschiedenster optischer Instrumente, bei denen es auf eine exakte Ausrichtung bezüglich einer optischen Achse ankommt.

Es kann aber auch nützlich sein, dass die zumindest teilweise lichtdurchlässige(n) Zone(n) und die absorbierende(n) Zone(n) längliche Formen aufweisen. Derartige Schlitzanordnungen mit erfindungsgemäß geringer Totzone eignen sich besonders für messtechnische Anwendungen.

Die Erfindung baut auf dem gattungsgemäßen Verfahren dadurch auf, dass die Unterbrechung der absorbierenden Halbleiterschicht durch lokales Entfernen der absorbierenden Schicht erzeugt wird und dass eine durchgängige Dotierung in eine die Unterbrechung umgebende Oberfläche der absorbierenden Halbleiterschicht und zumindest ein Teil der Oberfläche der zumindest teilweise lichtdurchlässigen Halbleiterschicht eingebracht wird. Auf diese Weise kann eine Anordnung hergestellt werden, welche die erfindungsgemäßen Vorteile aufweist. Insbesondere wird der Übergangsbereich zwischen absorbierenden und transparenten Zonen sehr klein gehalten, und eine Absorption von Licht kann bei der erfindungsgemäß hergestellten Anordnung auch in dem Flankenbereich der Unterbrechung stattfinden. Es liegt ferner ein Verfahren vor, mit dem im Vergleich zum Stand der Technik eine wesentlich reproduzierbare Breite des Übergangsbereiches erzeugt werden kann, da diese im Rahmen der Varianz der Eindringtiefe der Diffusion liegt.

Das erfindungsgemäße Verfahren ist besonders vorteilhaft dadurch weitergebildet, dass das lokale Entfernen der absorbierenden Schicht in einem ersten Maskenschritt erfolgt und dass die Dotierung in einem zweiten Maskenschritt erfolgt. Dabei ist als besonders vorteilhaft zu verzeichnen, dass die genaue Maskenlage im zweiten Schritt unkritisch bei der Definition des photoempfindlichen Bereiches ist.

Vorzugsweise erfolgt die Dotierung durch selektive Diffusion. Damit liegt ein bezüglich der Dicke der Dotierung gut handhabbares Verfahren vor.

Ebenfalls kann das Verfahren dadurch weitergebildet sein, dass die zumindest teilweise lichtdurchlässige Halbleiterschicht abgedünnt wird. Dies kann sinnvoll sein, wenn besondere Anforderungen an die Güte der optischen Transparenz gestellt sind, zum Beispiel die Forderung nach einem geringen optischen Wellenfrontfehler. In diesem Fall kann das Substrat von der Rückseite her bis auf eine geringere Dicke ausgehend von einer Dicke von 350 µm bis 50 µm abgedünnt werden.

Aus den selben Gründen kann es nützlich sein, wenn ein Durchgangsloch in die zumindest teilweise leitende Halbleiterschicht im Bereich der Unterbrechung der absorbierenden Halbleiterschicht eingebracht wird. Zur Herstellung eines solchen durchgehenden Loches kann eine nassbeziehungsweise trockenätztechnische Strukturierung oder eine Laserschneidtechnik angewendet werden. Die Ätzung kann von der Vorderseite oder von der Rückseite der Halbleiteranordnung erfolgen.

Vorzugsweise wird das Durchgangsloch durch Ätzverfahren eingebracht. Hiermit lassen sich in ihrer Gestalt definierte Durchgangslöcher erstellen.

Es kann auch nützlich sein, wenn das Durchgangsloch durch Laserschneidtechnik eingebracht wird. Auch auf diese Weise lassen sich wohldefinierte Strukturen bilden.

In einer vorteilhaften Weiterbildung des Verfahrens wird die Oberfläche der Anordnung mehrerer Halbleiterschichten zumindest teilweise mit einer Antireflexionsschicht versehen. Derartige Antireflexionsschichten verringern die Verluste durch Reflexion, wobei sie auf der Vorderseite und der Rückseite des optischen Detektors angebracht sein können.

Es ist von besonderem Vorteil, wenn die Neigung von Flanken im Bereich der Unterbrechung durch eine Kristallorientierung und/oder durch Strukturierungsverfahren beeinflusst wird. Auf diese Weise können der Anordnung je nach der spezifischen Aufgabe des optischen Detektors unterschiedliche Eigenschaften verliehen werden.

In einer bevorzugten Ausführungsform ist das Verfahren dadurch weitergebildet, dass als absorbierende Halbleiterschicht InGaAs verwendet wird und dass als zumindest teilweise lichtdurchlässige Halbleiterschicht InP verwendet wird. Damit ist der Detektor vorzugsweise bei einer optischen Wellenlänge zwischen 900 nm und 1200 nm einsetzbar. In diesem Wellenlängenbereich kann die Dicke der Absorptionsschicht gering gehalten werden, beispielsweise kleiner als 5 µm, und es ist kein durchgehendes Loch erforderlich. Vielmehr muss lediglich die Absorptionsschicht lokal entfernt werden. Das Trägersubstrat aus InP ist für optische Wellenlängen oberhalb von 900 nm transparent.

Es ist von besonderem Vorteil, dass an der durchgängigen p-Dotierung ein p-Kontakt angebracht und dass an der n-dotierten teilweise lichtdurchlässigen Halbleiterschicht ein n-Kontakt angebracht wird. Der Bereich der p-dotierten durchgängigen Schicht kann somit zur Anbringung eines elektrischen Kontaktes dienen, während die Rückseite, das heißt die Substratseite der Halbleiteranordnung zur Anbringung eines n-Kontaktes verwendet wird.

Nach dem Stand der Technik für pin-Dioden kann der n-Kontakt auch auf der Oberseite angebracht werden.

Besondere Vorteile hat die vorliegende Erfindung im Rahmen einer Verwendung bei Weltraumapplikationen.

Insbesondere kann eine solche Verwendung im Zusammenhang mit der Kommunikation zweier Satelliten von Vorteil sein.

Der Erfindung liegt die überraschende Erkenntnis zugrunde, dass durch die erfindungsgemäße durchgängige Dotierung eines Bereiches um die lichtdurchlässige Unterbrechung die "Totzone" zwischen transparenten und absorbierenden Bereichen sehr klein und in ihrer Breite reproduzierbar gehalten werden kann. Weitere Vorteile bestehen darin, dass die Trennung der lichtdurchlässigen Zone und der absorbierenden Zone selbstjustierend ist. Der Vorteil gegenüber Siliziumanordnungen besteht darin, dass die optisch absorbierenden Schichten aufgrund ihrer geringen Dicke mit geringem Aufwand und großer Genauigkeit selektiv geätzt werden können. Ebenfalls ist zu erwähnen, dass "Guard"-Ringstrukturen, das heißt zusätzliche von der aktiven Zone elektrisch getrennte Diffusionszonen, zwischen Lochbereich und aktiver Zone entbehrlich sind.

### Zeichnungen

Die Erfindung wird nun mit Bezug auf die begleitenden Zeichnungen anhand bevorzugter Ausführungsformen beispielhaft erläutert.

Dabei zeigt:
- Figur 1: eine Draufsicht auf einen erfindungsgemäßen Detektor;
- Figur 2: eine Schnittansicht entlang der in Figur 1 mit A-A' gekennzeichneten Ebene einer ersten Ausführungsform des Standes der Technik;
- Figur 3: eine Schnittansicht entlang der in Figur 1 mit B-B' gekennzeichneten Ebene einer ersten Ausführungsform des Standes der Technik;
- Figur 4: eine Schnittansicht entlang der in Figur 1 mit A-A' gekennzeichneten Ebene einer zweiten Ausführungsform des Standes der Technik;
- Figur 5: eine Schnittansicht entlang der in Figur 1 mit A-A' gekennzeichneten Ebene einer dritten Ausführungsform des Standes der Technik;
- Figur 6: eine Schnittansicht entlang der in Figur 1 mit A-A' gekennzeichneten Ebene einer vierten Ausführungsform des Standes der Technik;
- Figur 7: eine Schnittansicht entlang der in Figur 1 mit A-A' gekennzeichneten Ebene einer fünften Ausführungsform des Standes der Technik;
- Figur 8: eine Schnittansicht einer ersten Ausführungsform einer erfindungsgemäßen Halbleiteranordnung entlang einer Schnittebene, welche der in Figur 1 mit A-A' gekennzeichneten Schnittebene entspricht;
- Figur 9: eine Schnittansicht einer zweiten Ausführungsform einer erfindungsgemäßen Halbleiteranordnung entlang einer Schnittebene, welche der in Figur 1 mit A-A' gekennzeichneten Schnittebene entspricht; und
- Figur 10: eine Schnittansicht einer dritten Ausführungsform einer erfindungsgemäßen Halbleiteranordnung entlang einer Schnittebene, welche der in Figur 1 mit A-A' gekennzeichneten Schnittebene entspricht.

### Beschreibung der Ausführungsbeispiele

Bei den nachfolgenden Beschreibungen der Ausführungsbeispiele sind gleiche oder vergleichbare Komponenten mit gleichen Bezugszeichen gekennzeichnet.

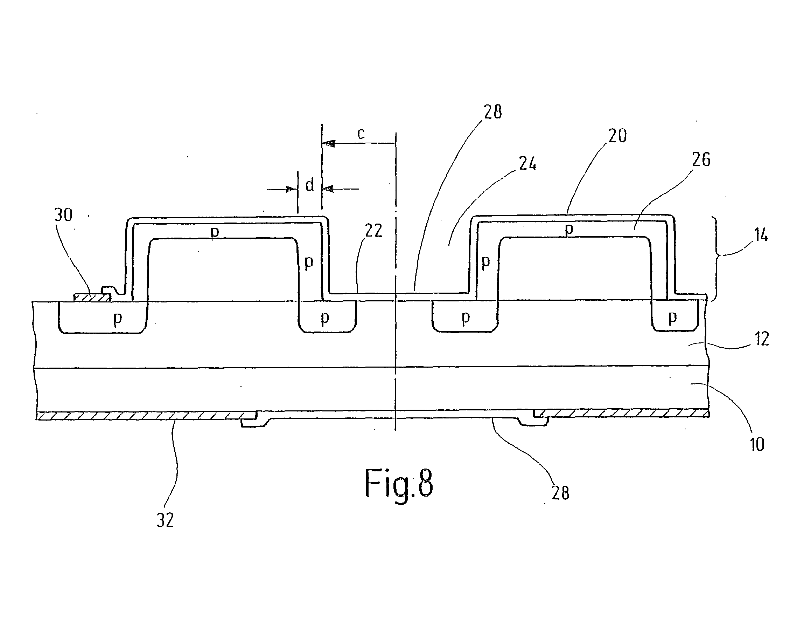

In Figur 8 ist eine Schnittansicht einer ersten Ausführungsform der Erfindung dargestellt. Die Schnittebene entspricht der Schnittebene, welche in Figur 1 durch die Linie A-A' gekennzeichnet ist. Zu bemerken ist allerdings, dass die p-dotierten Bereiche 150 in Figur 1 nicht den p-dotierten Bereichen gemäß Figur 8 entsprechen. Die Anordnung gemäß Figur 8 umfasst ein Trägersubstrat 10 aus n⁺-InP. Darüber ist eine Schicht 12 aus n-InP angeordnet. Dieser Schicht 12 ist eine InGaAs-Schicht 14 überlagert. Diese InGaAs-Schicht 14 ist strukturiert, wobei diese Strukturierung durch selektives, das heißt lokales Entfernen der Schicht in einem ersten Maskenschritt erfolgen kann. In einem zweiten Maskenschritt wird anschließend eine p-Dotierung 26 eingebracht. Das Einbringen dieser p-Dotierung 26 kann beispielsweise durch selektive Diffusion erfolgen. Die Zone mit p-Leitfähigkeit erstreckt sich über die Oberfläche der InGaAs-Schicht 14 sowie über die Flanke der InGaAs-Schicht 14, welche die Unterbrechung 24 umgibt, bis in einen Oberflächenbereich der InP-Schicht 12.

Die Oberflächen der Anordnung sind teilweise von Antireflexionsschichten 28 bedeckt, um Verluste durch eine Reflexion zu verringern. Ein p-Kontakt 30 ist an der InP-Schicht 12 im Bereich der p-Leitfähigkeit angeordnet. Der n-Kontakt 32 ist an der Substratschicht 10 angeordnet.

Verwendet man die Schichtanordnung gemäß Figur 8 als optischen Detektor, beispielsweise in einem Wellenlängenbereich von 1064 nm, so ist die InGaAs-Schicht 14 absorbierend, während die InP-Schichten 10, 12 lichtdurchlässig sind. Somit entspricht die Unterbrechung 24 einer lichtdurchlässigen Zone 22. Die die Unterbrechung 24 umgebenden Bereiche der Schicht 14 wirken als absorbierende Zone 20.

Der effektive Übergangsbereich zwischen der transparenten Zone 22 und der aktiven absorbierenden Zone 20, das heißt dem Teil der absorbierenden Zone 20, in welcher ein Lichteinfall zur Erzeugung eines Photostroms führt, ist im Wesentlichen durch die Breite der p-Dotierung d in dem die Unterbrechung 24 umgebenden Flankenbereich bestimmt. Die Eindringtiefe der p-Dotierung d kann im Allgemeinen wesentlich kleiner als 10 µm sein, wobei typische Werte im Bereich zwischen 0,5 µm und 1 µm liegen.

Im Hinblick auf eine Exzentrizität der Anordnung ist als besonders vorteilhaft zu erwähnen, dass die absorbierende Zone 20 und die lichtdurchlässige Zone 22 in einem einzigen Maskenschritt definiert werden, nämlich beim Entfernen der absorbierenden Schicht zur Erzeugung der Unterbrechung 24. Ebenfalls ist vorteilhaft, dass in demselben Maskenschritt Erhebungen in der Schicht 14 erzeugt werden können. Solche sogenannten Mesen können als Raststrukturen bei der Montage auf einen Träger zur präzisen passiven Justierung verwendet werden. Dies kann zur genauen Ausrichtung auf eine nachfolgende optische Verarbeitungseinheit verwendet werden.

Beim zweiten Maskenschritt, das heißt in dem Schritt, in welchem die p-Leitfähigkeit in die Oberfläche der Schichten 14, 12 eingebracht wird, ist die genaue Maskenlage zur Definition des photoempfindlichen Bereiches unkritisch. Dies ist ein weiterer Vorteil im Hinblick auf die Präzision eines optischen Detektors, in welchem eine Anordnung gemäß Figur 8 verwendet wird.

Figur 8 kann noch einen weiteren Aspekt eines erfindungsgemäßen optischen Detektors darstellen. Die in Figur 8 gezeigte Schnittansicht kann einem Schnitt entlang einer Ebene entsprechen, die einer solchen Ebene entspricht, welche in Figur 1 mit der mit B-B' gekennzeichneten Linie definiert ist. In diesem Fall kann auch in diesen Bereichen eine Erhöhung der Leckströme vermieden werden.

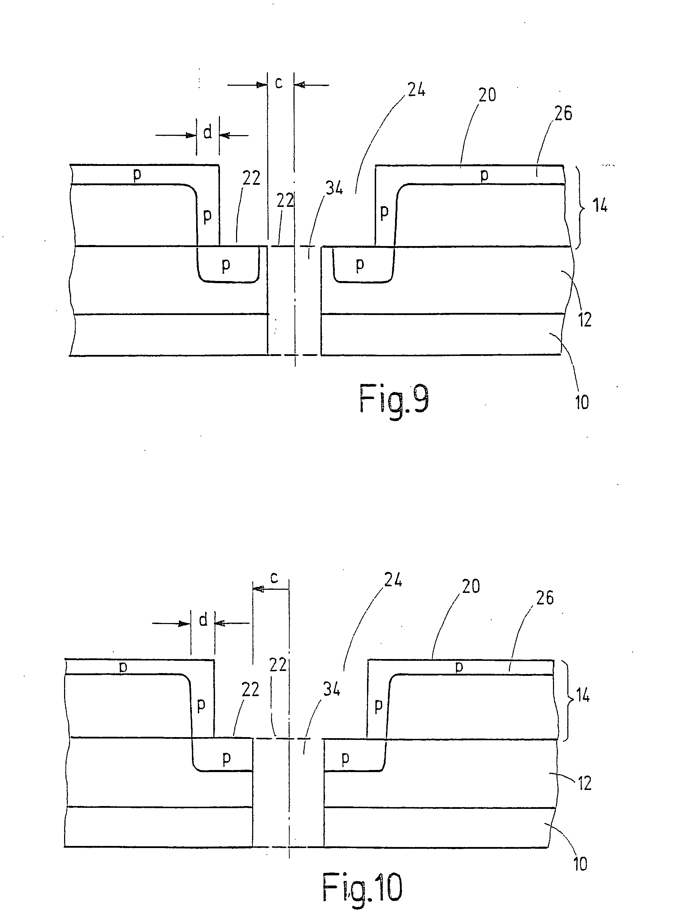

Figur 9 zeigt eine Anordnung, welche in weiten Teilen der Anordnung gemäß Figur 8 entspricht. Im Unterschied zu Figur 8 ist in dem dargestellten Teil der Anordnung die Schicht 14 nur im Bereich der Unterbrechung 24 entfernt worden. Ein weiterer Unterschied zu Figur 8 besteht darin, dass zur Verbesserung der Transparenz der lichtdurchlässigen Zone 22 ein Durchgangsloch 34 in den Schichten 10, 12 vorgesehen ist. Auch bei der Anordnung gemäß Figur 9 können Antireflexionsschichten vorgesehen sein, welche aus Gründen der Übersichtlichkeit, ebenso wie die p- und n-Kontakte nicht explizit dargestellt sind.

Figur 10 entspricht in weiten Teilen Figur 9. Im Unterschied zu Figur 9 geht bei Figur 10 der p-dotierte Bereich 26 bis zu dem Durchgangsloch 34, welches bei der Anordnung gemäß Figur 10 einen größeren Radius c hat als bei der Anordnung gemäß Figur 9. Auch bei der Anordnung gemäß Figur 10 können Antireflexionsschichten vorgesehen sein. Ebenso sind aus Gründen der Übersichtlichkeit die n- und p-Kontakte nicht explizit dargestellt.

Die vorhergehende Beschreibung der Ausführungsbeispiele gemäß der vorliegenden Erfindung dient nur zu illustrativen Zwecken und nicht zum Zwecke der Beschränkung der Erfindung. Im Rahmen der Erfindung sind verschiedene Änderungen und Modifikationen möglich, ohne den Umfang der Erfindung sowie ihre Äquivalente zu verlassen.

## Patentansprüche

1. Optischer Detektor mit einer Anordnung mehrerer Halbleiterschichten (10, 12, 14) mit
- mindestens einer in einem bestimmten Wellenlängenbereich absorbierenden Zone (20) und
- mindestens einer in dem bestimmten Wellenlängenbereich zumindest teilweise lichtdurchlässigen Zone (22),
- wobei eine Halbleiterschicht (14) in dem bestimmten Wellenlängenbereich absorbierend ist und eine darunter liegende Halbleiterschicht (10, 12) in dem bestimmten Wellenlängenbereich zumindest teilweise lichtdurchlässig ist und
- wobei die mindestens eine lichtdurchlässige Zone (22) durch eine Unterbrechung (24) der absorbierenden Halbleiterschicht (14) realisiert ist,
**dadurch gekennzeichnet, dass** eine die Unterbrechung (24) umgebende Oberfläche der absorbierenden Halbleiterschicht (14) und zumindest ein Teil der Oberfläche der zumindest teilweise lichtdurchlässigen Halbleiterschicht (10, 12) eine durchgängige Dotierung (26) aufweist.

2. Optischer Detektor nach Anspruch 1, **dadurch gekennzeichnet,**
- **dass** die absorbierende Halbleiterschicht (14) InGaAs ist und
- **dass** die zumindest teilweise lichtdurchlässige Halbleiterschicht (10, 12) InP ist.

3. Optischer Detektor nach Anspruch 1 oder 2, **dadurch gekennzeichnet,**
- **dass** die durchgängige Dotierung (26) eine p-Dotierung ist und
- **dass** die zumindest teilweise lichtdurchlässige Halbleiterschicht (10, 12) n-dotiert ist.

4. Optischer Detektor nach einem der vorangehenden Ansprüche, **dadurch gekennzeichnet, dass** zwei zumindest teilweise lichtdurchlässige Halbleiterschichten (10, 12) mit unterschiedlichen Dotierungskonzentrationen vorgesehen sind.

5. Optischer Detektor nach einem der vorangehenden Ansprüche, **dadurch gekennzeichnet, dass** die Oberflächen der Anordnung mehrerer Halbleiterschichten (10, 12, 14) zumindest teilweise mit einer Antireflexionsschicht (28) versehen sind.

6. Optischer Detektor nach einem der vorangehenden Ansprüche, **dadurch gekennzeichnet,**
- **dass** an der durchgängigen p-Dotierung (26) ein p-Kontakt (30) vorgesehen ist und
- **dass** an der n-dotierten teilweise lichtdurchlässigen Halbleiterschicht (10, 12) ein n-Kontakt (32) vorgesehen ist.

7. Optischer Detektor nach einem der vorangehenden Ansprüche, **dadurch gekennzeichnet, dass** die zumindest teilweise lichtdurchlässige Halbleiterschicht (10, 12) abgedünnt ist.

8. Optischer Detektor nach einem der vorangehenden Ansprüche, **dadurch gekennzeichnet, dass** ein Durchgangsloch (34) in der zumindest teilweise lichtdurchlässigen Halbleiterschicht (10, 12) im Bereich der Unterbrechung (24) der absorbierenden Halbleiterschicht (14) vorgesehen ist.

9. Optischer Detektor nach einem der vorangehenden Ansprüche, **dadurch gekennzeichnet, dass** die zumindest teilweise lichtdurchlässige(n) Zone(n) (22) und die absorbierende(n) Zone(n) (20) zirkularsymmetrisch sind.

10. Optischer Detektor nach einem der vorangehenden Ansprüche, **dadurch gekennzeichnet, dass** die zumindest teilweise lichtdurchlässige(n) Zone(n) (22) und die absorbierende(n) Zone(n) (20) längliche Formen aufweisen.

11. Verfahren zum Herstellen einer Anordnung mehrerer Halbleiterschichten mit
- mindestens einer in einem bestimmten Wellenlängenbereich absorbierenden Zone (20) und
- mindestens einer in dem bestimmten Wellenlängenbereich zumindest teilweise lichtdurchlässigen Zone (22),
- wobei eine Halbleiterschicht (14) in dem bestimmten Wellenlängenbereich absorbierend ist und eine darunter liegende Halbleiterschicht (10, 12) in dem bestimmten Wellenlängenbereich zumindest teilweise lichtdurchlässig ist und
- wobei die mindestens eine lichtdurchlässige Zone (22) durch eine Unterbrechung (24) der absorbierenden Halbleiterschicht (14) realisiert ist,
**dadurch gekennzeichnet,**
- **dass** die Unterbrechung (24) der absorbierenden Halbleiterschicht (14) durch lokales Entfernen der absorbierenden Halbleiterschicht (14) erzeugt wird und
- **dass** eine durchgängige Dotierung (26) in eine die Unterbrechung (24) umgebende Oberfläche der absorbierenden Halbleiterschicht (14) und zumindest einen Teil der Oberfläche der zumindest teilweise lichtdurchlässigen Halbleiterschicht (10, 12) eingebracht wird.

12. Verfahren nach Anspruch 11, **dadurch gekennzeichnet,**
- **dass** das lokale Entfernen der absorbierenden Schicht (24) in einem ersten Maskenschritt erfolgt und
- **dass** die Dotierung in einem zweiten Maskenschritt erfolgt.

13. Verfahren nach Anspruch 11 oder 12, **dadurch gekennzeichnet, dass** die Dotierung durch selektive Diffusion erfolgt.

14. Verfahren nach einem der Ansprüche 11 bis 13, **dadurch gekennzeichnet, dass** die zumindest teilweise lichtdurchlässige Halbleiterschicht (10, 12) abgedünnt wird.

15. Verfahren nach einem der Ansprüche 11 bis 14, **dadurch gekennzeichnet, dass** ein Durchgangsloch (34) in die zumindest teilweise lichtdurchlässige Halbleiterschicht (10, 12) im Bereich der Unterbrechung (24) der absorbierenden Halbleiterschicht (14) eingebracht wird.

16. Verfahren nach einem der Ansprüche 11 bis 15, **dadurch gekennzeichnet, dass** das Durchgangsloch (34) durch Ätzverfahren eingebracht wird.

17. Verfahren nach Anspruch 16, **dadurch gekennzeichnet, dass** das Durchgangsloch (34) durch Laserschneidtechnik eingebracht wird.

18. Verfahren nach einem der Ansprüche 15 bis 17, **dadurch gekennzeichnet, dass** die Oberflächen der Anordnung mehrerer Halbleiterschichten (10, 12, 14) zumindest teilweise mit einer Antireflexionsschicht (28) versehen werden.

19. Verfahren nach einem der Ansprüche 11 bis 18, **dadurch gekennzeichnet, dass** die Neigung von Flanken im Bereich der Unterbrechung (24) durch eine Kristallorientierung und/oder durch Strukturierungsverfahren beeinflusst wird.

20. Verfahren nach einem der Ansprüche 11 bis 19, **dadurch gekennzeichnet,**
- **dass** als absorbierende Halbleiterschicht (14) InGaAs verwendet wird und
- **dass** als zumindest teilweise lichtdurchlässige Halbleiterschicht (10, 12) InP verwendet wird.

21. Verfahren nach einem der Ansprüche 11 bis 20, **dadurch gekennzeichnet,**
- **dass** an der durchgängigen p-Dotierung (26) ein p-Kontakt (30) angebracht wird und
- **dass** an der n-dotierten teilweise lichtdurchlässigen Halbleiterschicht (10, 12) ein n-Kontakt (32) angebracht wird.

22. Verwendung eines optischen Detektors nach einem der Ansprüche 1 bis 10 und/oder eines optischen Detektors der nach einem der Ansprüche 11 bis 21 hergestellt ist, bei Weltraumapplikationen.

23. Verwendung nach Anspruch 22 bei der Kommunikation zwischen Satelliten.
